# NEW EUROPEAN PATENT SPECIFICATION

(11) **EP 0 495 636 B2**
(45) Date of publication and mention of the opposition decision: **18.09.2002**
(45) Mention of the grant of the patent: 17.09.1997
(21) Application number: 92300319.8
(22) Date of filing: 15.01.1992
(51) Int. Cl.: G01R 31/36, H01M 10/48

(54) **Battery with tester label**
Batterie mit Testeretikett
Batterie avec étiquette à testeur

(30) Priority: 15.01.1991 US 641394
(43) Date of publication of application: 22.07.1992
(73) Proprietor: EVEREADY BATTERY COMPANY, INC., St. Louis Missouri 63164 (US)
(72) Inventor: Bailey, Jean W., Ohio 44028 (US); Tucholski, Gary R., Ohio 44130 (US); Huhndorff, Harry R., Ohio 44140 (US)
(74) Representative: Lord, Hilton David

(56) References cited:
- EP-A- 0 450 938
- EP-A- 0 523 901
- DE-A- 4 106 664
- US-A- 1 497 388
- US-A- 4 723 656
- US-A- 5 015 544

## Description

The present invention relates to a battery or batteries having a label and a tester therefor.

Tester strips for batteries are available individually and in association with a package containing the batteries, and typically consist of multilayer strips. This construction generally comprises a substrate layer onto which is deposited an electrically conductive layer that has terminal end portions. Also disposed on the substrate is a thermally sensitive material. This material changes colour when heated and is in thermal contact with the electrically conductive layer. When the terminals of the tester strip are brought into contact with the corresponding terminals of a battery, heat is generated in the conductive layer, the amount of heat generated being proportional to the remaining power of the battery. The heat thereby generated acts on the thermally sensitive material, causing it to change colour.

One disadvantage with such tester strips is that the strip or package is separated from the batteries to be tested when the batteries are removed from their packaging. If the tester strip is separate from the packing, it still becomes separated when the batteries are employed. In addition, because of their shape and style, the testing strips can be easily misplaced or discarded. Thus, when a need arises to test batteries, it may be difficult or impossible to locate the tester strips. Such individual tester strips also tend to be difficult to use

EP-A-450 938, relevant under EPC Article 54(3), discloses a battery having a label and a tester therefor, the tester forming part of the label and comprising a circuit whose ends contact or are contactible with the terminals of the battery, a portion of the circuit between the two ends providing an area of predetermined resistance, an indicator being associated with the area of resistance and being activatable thereby by a current flowing therethrough and wherein activation of the indicator gives an indication of the remaining power in the battery. Connection of the circuit with the negative end cap is made via an extra foil strip.

In a first aspect, the present invention provides a battery in accordance with claim 1.

The tester of the present invention may be provided in any suitable form. As it forms a part of the label, there is no particular requirement for robustness, and the various components may merely take the form of films printed onto the label. However, the tester may also be manufactured independently, and only associated with the label at a later stage.

The tester comprises a circuit having a resistance, so that when a current flows through the tester, the results are detectable. The effect of the current may be heat, for example, so that a thermochromic detection system may serve to provide the necessary indication of the battery's status. Such inks are well known, and have been used for some time in desk thermometers, for instance.

Alternatively, the effects of the current may be measured by detecting the elecltic field, in which case, electrochromic inks would suffice.

In order to give an indication of the status of the battery, various methods may be employed. At its simplest, the only requirement for the tester is to give an indication that the battery has discharged to a grven level, so that all that is necessary is a cut-off, beyond which the indicator is or is not activated, according to the system.

It will be appreciated that most customers would prefer that the system gave a calibrated reading, so that, when the battery was tested, they could obtain some idea of how much life was left in the battery. Such systems are preferred, and there are various ways of providing such calibration in the system

One way to provide calibration is to vary the resistance in some way along the length of the tester. Such variance may be achieved, for example, by varying the width of the tester, so that the narrowest point would heat up the most, the wide base only heating up when the battery was at full charge. Thus, as the battery is discharged, the amount of the resistor heating up to the required degree is reduced, until only the apex heats up sufficiently. A printed scale by the resistor could then give an an indication of battery life-expectancy. In such a system, the thermochromic or electrochromic ink need only be wide enough for detection at any one point, and does not need to get wider with the resistor, for example.

In a-further aspect, layers of the indicator ink may be provided, so that all layers turn colour at full charge, but only one, for example, at low charge Such layers may be stepped so that, at full charge, if all layers clear, a logo such as "FULL CHARGE" would be visible. All other layers in such a system would also be visible, with the highest giving the reading At low charge, only the logo "LOW CHARGE" might be visible

The testers of the invention may be buitt into the labels, if desired One suitable construction is to sandwich the tester between layers of label. Ends of the tester are then exposed to be able to contact the terminals of the battery.

It is generally preferred that one end of the tester is secured to one of the terminals, so that to operate the tester only one end needs to be manipulated. One end of the tester is preferably biassed away from its terminal, manual pressure being sufficient to complete the circuit with the battery. Both ends may be biassed away from their terminals, perhaps if it is strongly desired to avoid accidental activation, but this requires bringing both ends into contact with the terminals, and is not generally preferred.

One of the ends of the tester is biassed away from its terminal. This may be achieved simply by having the end protrude over the terminal, so that it is necessary to press on the end to make contact. It will also be appreciated that the end should then return to the starting position if possible. This may be achieved by incorporating the end in a resilient piece of the battery label, or by constructing at least that part of the tester from a resilient material. Suitable embodiments will be apparent to those skilled in the art.

The label may have two layers, with a hole in the bottom layer and an end of the tester located over this hole but attached to the top layer Pressure on the top layer then causes contact with the terminal, for example the battery casing, and the resilience of the layer then allows the end to spring back after testing.

In one embodiment, the battery is attached to the label that contains a tester for the battery, wherein the battery has a conductive housing in contact with one of the electrodes of the battery, and a conductive cover on one of its ends in contact with the opposite electrode of the battery; and the label is comprised of a tester circuit that has a first end in contact with the battery housing and a second end that is resilient and disposed over but out of contact with the conductive cover of the battery to provide a switch for the tester, which ends are electrically connected to each other via an area of controlled resistivity, and which circuit is electrically insulated from the terminals of the battery except for the first and second terminal contact ends; and an indicating material disposed in responsive contact with the area of controlled resistivity in the tester circuit.

It is preferred that the first end is disposed over and out of contact with the housing to provide a second switch forthe tester circuit. It is particularly preferred that the indicating material is thermochromic ink.

The present invention also provides, in a further embodiment, a battery to which is attached a label that contains a tester for the battery. The battery has a conductive housing in contact with one of the electrodes of the battery, and a conductive cover on one of its ends in contact with the opposite electrode of the battery. The label is comprised of a tester circuit that has a first end in contact with the battery housing and a second end that is resilient and disposed over but out of contact with the conductive cover of the battery to provide a switch for the tester. The ends are electrically connected to each other via an area of controlled resistivity. The circuit is electrically insulated from the terminals of the battery except for the first and second terminal contact ends. An indicating material is disposed in responsive contact with the area of controlled resistivity in the tester circuit

The batteries of the present invention have testers built into the label so that whenever it is desired, the battery can be tested. The batteries are easily tested by completing the tester circuit in the label and without the use of components not associated with the battery or label.

Suitable batteries for use in the present invention are primary or secondary batteries that have positive and negative terminals These batteries generally comprise an anode, a cathode and electrolyte contained in a sealed housing. The housing typically has an opening in one end that is sealed and closed with a cover. This cover is usually in electrical contact with either the cathode or anode to provide a terminal of the battery.

In addition to its use as an indicator of the remaining capacity of a primary cell, the label tester of the present invention may also be used on a rechargeable cell, for example, a rechargeable alkaline MnO₂ cell, to indicate when the cell should be recharged. This may conveniently be done by appropriate selection of the indicating material to ensure activation at a predetermined voltage level to display an appropriate message to the user.

The label provides a means for testing the capacity of the battery to which it is attached, and comprises means for completing the circuit between the terminals of the battery, means for responding to the capacity of the battery and means for indicating the capacity of the battery.

The electrically conductive material of the tester circuit may be a metallic foil. or a metallised plastic layer, for example. Other examples include electrically conductrve paints or inks, such as those that contain graphite, carbon or metals, or combinations thereof, as the conductive materials.

The electrically conductive material is configured so as to have first and second ends that are connected to each other via an area of controlled resistivity, the first end making contact with a first terminal of the battery, the second end making contact with a second terminal of the battery, with one of the ends biassed away from its terminal . Connection of these terminal contact ends to the terminals of the battery completes the tester circuit, thereby allowing electric current to flow through the area of controlled resistivity.

The term "controlled resistivity", as used herein, means that the resistance of the tester is controlled, or selected, so as to be within a range that the responsive means is activated when an appropriate current passes through the area of controlled resistivity.

The resistance in the area of controlled resistivity may vary or be constant. In one preferred embodiment, the tester has a varying resistance to indicate the relative remaining useful life of a battery. For example, the current flowing through the tester circuit will generate a specific temperature. The temperature achieved will be proportional to the amount of current supplied by the battery. Thus, the area of controlled resistivity may be of varying width, for example, tapered, or of varying thicknesses to achieve a temperature gradient.

Alternatively, the area may be of constant width and constant thickness. In addition, when using thermochromic materials, materials activated at different temperatures may be used along an area of constant resistance, or continuous or discontinuous segments of a thermochromic material used along an area of variable resistance.

One or both terminal contact ends of the circuit are out of contact with the terminals of the battery, so that the tester circuit is open, and the testing means further comprises means for switching the tester circuit on. The tester circuit has one or more switches. In a preferred embodiment of the invention, the anode or the cathode is in electrical contact with the conductive housing of the battery. In this embodiment, one of the terminal contact ends of the tester circuit may be connected to the housing, or positioned out of contact with the housing, for example by a small opening in a layer disposed between the housing and the end of the tester circuit. This opening can then act as a switch for the tester circuit. By forcing the terminal contact end into contact with the housing through the opening, the switch is closed and the tester circuit is completed so that the battery can be tested. This contact may be conveniently made by applying finger or thumb pressure to the switch areas.

In an alternative switch embodiment, a circuit terminal is in permanent contact with the housing, and the switch is provided by extending an end of the circuit over the opposing terminal end of the battery. Usually the housing of the cell is in contact with the cathode to provide the positive terminal, and the end of the cell is in contact with the anode to provide the negatrve terminal In this embodiment, the end of the tester circuit extends over the negative terminal and is spaced apart from the terminal to provide an open circuit. The circuit may then be closed by forcing the end of the circuit into contact with the negative terminal of the cell.

In yet another embodiment, two switches may be provided by combining the opening in a layer of the label and the spaced apart arrangement between the negative terminal and the extending end of the tester circuit. In this embodiment, both switches need to be forced into contact with the cell to close the circuit.

The testing means comprises a means for indicating the capacity of the battery. The indicating means is in responsive contact with the area of controlled resistivity and responds to and indicates the-state that is present in that area. For example, a temperature increase will be generated in that area when a current flows through the tester circuit. Also. the current itself may indicate such a state. If the indicating means is a thermally sensitive material, then it is in thermal contact with the area of controlled resistivity. If the indicating means is an electrical field or voltage sensitive material, for example, then the indicating means will be in electrical contact with the area of controlled resistivity. The indicating means then indicates the capacity of the battery to the consumer. This indication may be a simple, qualitative indication, such as a "good" or "bad", or quantitative such as a remaining percentage of useful life.

In one embodiment, the indicating means is a thermally sensitive material that is in thermal contact with the area of controlled resistivity of the tester circuit. Thus, the heat generated in the area of controlled resistivity in the tester circuit is transferred to the thermally sensitive material. Thermally sensitive materials change colour in response to a temperature change. The material is readily viewable to a consumer and so the consumer, based on the colour change, may determine whether the battery is good or needs to be replaced.

To facilitate the colour change effect, the thermally sensitive material may be placed over a contrasting colour layer. This layer may be applied such as by printing directly onto the film base or on the electrically conductive circuit. A message may be printed or stenciled onto the contrasting colour layer for viewing by the consumer when the thermally sensitive material changes colour. An alternative means of providing a message employs a stencil in the form of a thermally non-conductive layer, for example, a layer of double-faced tape, in which the message is cut out of the thermally non-conductive layer so that a thin layer of insulating air is left in that area under the thermally sensitive material. When the tester is activated, this cut-out message portion, which has poorer thermal conductivity than the surrounding area, results in the thermally sensitive material directly over the message area changing colour, while the surrounding thermally sensitive material, which serves as a heat sink, remains the original colour, thus outlining the message.

The above stencil may also be reversed, so that the message is made of the thermally non-conductive layer and is surrounded by the air insulation layer. When such a tester is activated, the thermally sensitive material directly over the message portion will remain the original colour because of better thermal conductivity, and the surrounding thermally sensitive material over the air insulation layer will change colour, thereby outlining the message.

Examples of suitable thermally sensitive materials are liquid crystal materials and thermochromic inks. The indicating material may be used singly or in combination. For example, in one embodiment, different layers of the indicating material are employed. The layers are activated at different temperatures or states and may be designed to change different colours at different temperatures. For example, the layer of material activated at the bottom layer and the upper layers may be arranged in decreasing temperature of activation with the lowest temperature material in the top layers.

Alternatively, the indicating material may be designed to test the battery at different ambient temperatures by using materials that activate at different temperatures. The label may include different tester circuits for different ambient temperatures. The material activatable at the corresponding temperature would then be associated with the different circuits. For example, the label may be designed with a window for testing at 40°F, a window for testing at 70°F and a window for testing at 90°F. Depending on what the ambient temperature is, the consumer would look at the corresponding window.

Suitable examples of liquid crystal materials include the cholesteric type, such as cholesteryl oleate, cholesteryl chloride and cholesteryl caprylate.

Examples of suitable thermochromic inks include those comprising a dye, developer and desensitising agent, such as those disclosed in US-A-4,835,475. Suitable-inks may be obtained from Japan Capsule Products and Sakura Colour Products Corp.

In another embodiment, the indicating and responding means are materials that respond to a voltage change or electric field. These materials respond directly to the remaining capacity of the battery as the current flows through the tester circuit, and are disposed in electrically responsive contact with the area of controlled resistivity. Suitable materials for this purpose are known as electrochromic materials and are commercially available from the Donnelly Corporation, for example.

Labels useful in the present invention may also comprise such additional layers as insulating layers, printing layers and protective layers. Suitable materials for use as the different layers are those typically used in battery labels and include plasticised or unplasticised polyvinyl chloride (UPVC), metallic films and paper, and may be prepared by known methods, such as laminating the layers together. The layers may be adhered to each other by an adhesive. In embodiments where conductive ink is in contact with the adhesive, it is desirable to employ a primer layer or sealant layer between the conductive ink and adhesive. Suitable primers and adhesives include UV-cured dielectric materials such as Dielectric LV-3728-39 from Emerson and Cuming Inc., Dielectric ML-25198 from Acheson Colloids, and Liquitex acrylic gesso from Binney & Smith, Inc. The label may be attached to the battery by the use of an adhesive. The label may be in the form of individual sheets which will have a seam or in the form of a shrinkable tube in which a battery is encased.

A preferred tester label comprises a base insulative layer adhered to the housing of the battery. The housing is in electrical contact with either the anode or cathode of the battery. The insulative layer has an opening in it. The tester circuit is placed on the surface of this insulator One of the terminal contact ends of the circuit is aligned with the opening in the insulator. The other terminal contact end of the circuit is in contact with the terminal of the battery that is not in contact with the housing. The indicating material is placed over the area of controlled resistivity of the circuit. The indicating material may be placed directly on the tester circuit or it may be placed on a separate layer that is placed over the tester circuit. Preferably, the indicating material is a thermochromic ink and is in thermally transferable contact with the area of controlled resistivity. Finally, a protective layer is placed over the indicating material. The type of protective layer is selected so that the indicating material may be observed by the user. To test the battery, the user presses the label at the point above the opening in the insulator layer to establish contact between the terminal contact end of the circuit and the conductive battery housing. As the circuit is completed, a temperature increase is generated in the area of controlled resistivity and which is transferred to the indicating material. If the necessary temperature is reached, the indicating material will so indicate and the user can determine (at ambient temperature) the remaining capacity of the battery.

To prepare the individual sheet labels, a shrinkable plastic film may be printed with a thermally sensitive material in a test window area. Any graphics or decorative metallisation to be included may also be printed on this film. On the reverse side of this film the electrically conductive tester circuit is printed, and an insulative layer is placed over this conductive layer. The tester circuit may also be hot stamped onto the film, or inserted as a separate component of a metal foil or or metallised plastic. The insulative layer prevents the conductive layer from contacting the battery housing and provides thermal and electrical insulation. The insulative layer may completely cover the conductive layer, and terminal connectors may be used to connect the battery terminals with the terminal contact ends of the tester circuit. Alternatively, openings may be left in the insulative layer through which the conductive portion of the tester circuit may be directly connected to the terminals of the battery. An adhesive may be added to the back of the label, except for the portion in which the tester circuit will contact the terminals. The tester circuit may also be printed on a continuous layer of adhesive. If so, it is desirable to add the sealer or primer layer between the tester circuit and adhesive. The adhesive side of the label is then joined to a releasable material such as a silicone-coated paper web to form a label carrier The labels may then be die cut and converted to rolls ready for use. After applying these labels to a battery, a clear protective shrink film may be applied over the label. This film is preferably in the form of a shrink tube, and unplasticised PVC is a preferred material.

To prepare the labels on a shrinkable tube, after forming the label as generally described above, the label may be placed around a mandrel and welded lengthwise to form a tube. The tube is flattened, wound on a roll and is then ready for use.

In forming the labels, it is desirable that the insulative layers be built up around any openings between the battery terminals and the ends of the tester circuit. This increased thickness will assist in preventing accidental activation of the tester and resultant premature discharge of the battery.

In a preferred method, unplasticised polyvinyl chloride (UPVC) film may be metallised, for example, with aluminium, on one surface. The UPVC film provides an insulative layer and the metallised layer can provide the conductive layer of the label. Portions of the conductive layer may be removed to establish positive and negative terminal contact ends of the tester circuit and an area of controlled resistivity. The portions may be removed by chemical etching or by photo resist techniques. Alternatively, the deposition of the metallised layer may be done in the desired tester circuit pattern.

Another layer of insulation, such as additional PVC or a UV-cured coating, such as those employing epoxy resin, or a thin foamed plastic layer, may be deposited over the conductive layer. The insulating layer may also be an air pocket suitably formed by the use of a thin solid spacer, for example, of foamed plastic or adhesive, so shaped as to provide the desired dimensions. Areas of the conductive layer may be exposed through this insulative layer to provide switch contact areas. One or more switch areas may be provided. Advantageously, a relatively thick layer of additional insulative material is placed around the switch areas to increase the distance needed to close the switch and, thus, prevent inadvertent closure. A foaming ink is suitable for this purpose. This insulative layer may also be placed over the area of controlled resistivity. An adhesive layer may then be placed overthis insulative layer. The adhesive layer may have openings in it so that the conductive layer can contact the terminals of the battery. This label may then be laminated to a carrier web, such as silicone-coated paper.

On the other surface of the UPVC layer may be deposited an indicating material, such as a thermochromic ink. This material is placed over the area of increasing resistivity of the tester circuit. This outer layer may also contain printing and graphics. This printing or graphics may also be a contrasting colour layer disposed between the tester circuit and indicating material. Thus, when the circuit is closed and the indicating material responds to the circuit, the contrasting layers with any message may be viewed. The final layer can then be a protective coating or film deposited over the label.

It will be appreciated that the layers and steps described above may be altered or rearranged in many ways to provide the label with a tester circuit.

The present invention will now be further illustrated with respect to the accompanying drawings, in which:
Figure 1A is a comparative Figure showing an exploded view of a multilayered label that has a single switch area;
Figures 1B and 1 C show a switch area;
Figures 2 to 6 are comparative Figures, and

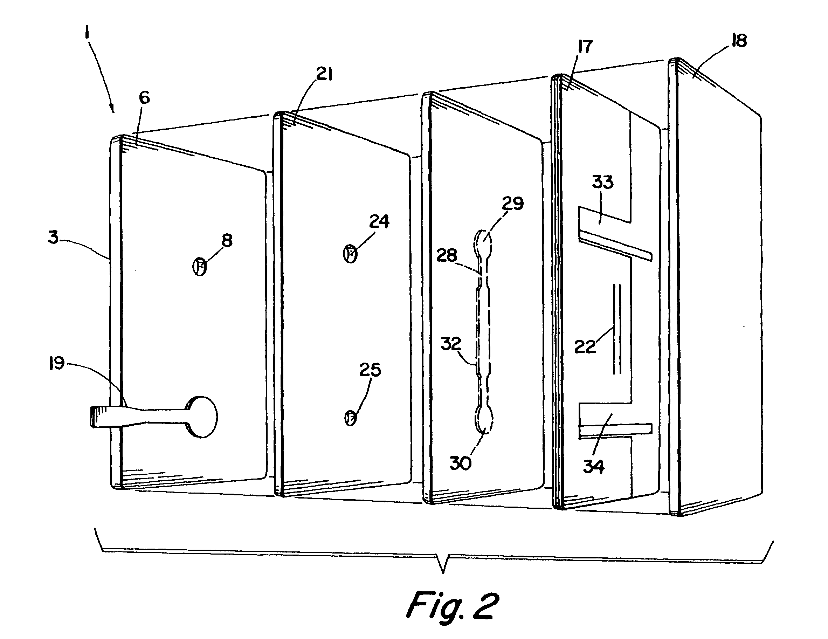

Figure 2 shows an exploded view of a multilayered label that has two switch areas;

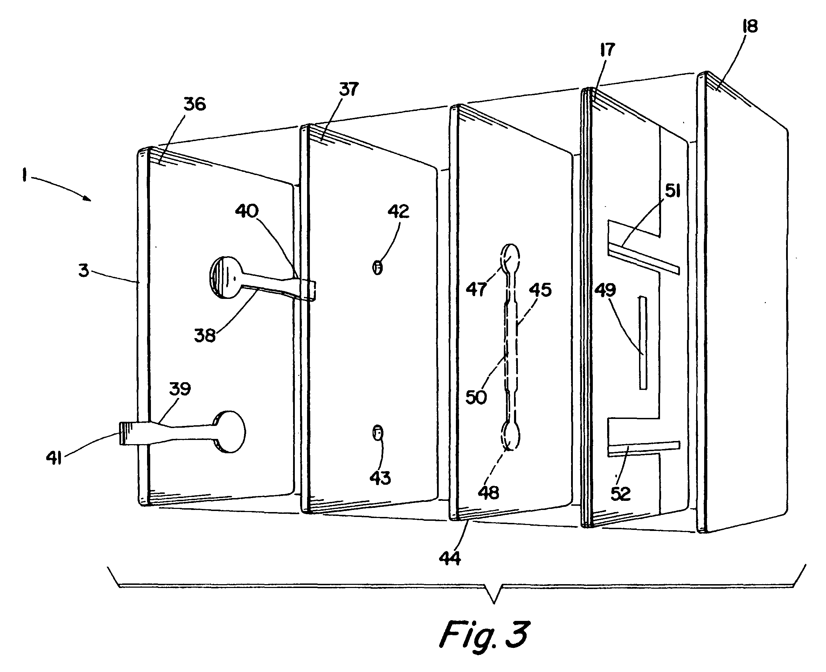

Figures 3 to 5 show alternative embodiments of the dual switch multilayered label:

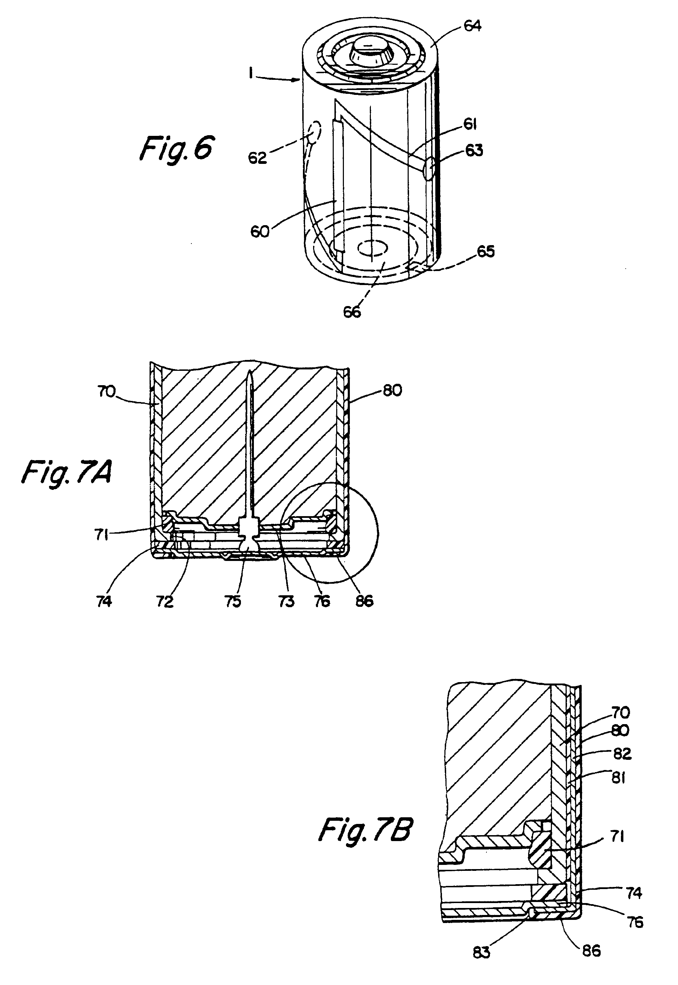

Figure 6 shows a battery to which is attached a tester label;

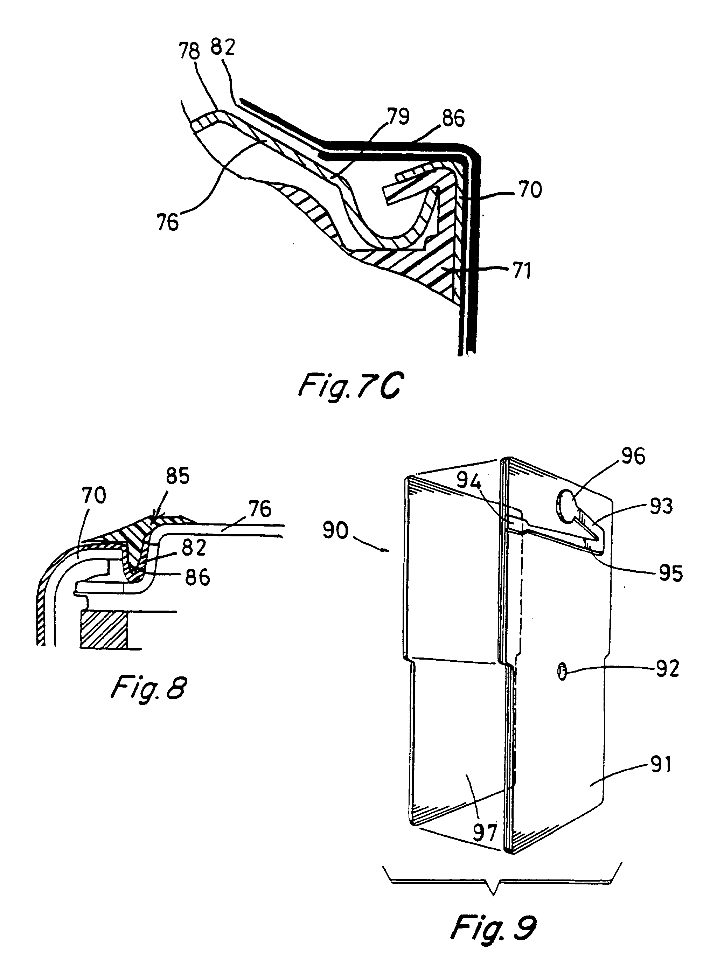

Figure 7A shows the area of contact between the tester circuit and a terminal of the battery, while Figure 7B shows an enlargement of the area, and Figure 7C shows an enlargement of the area of contact between the tester circuit and a terminal of the battery wherein the tester circuit tab is spaced apart from the terminal so as to serve as a switch;
Figure 8 shows a further embodiment wherein permanent contact between an end terminal of the battery and the tester circuit is ensured through a snap ring assembly;
Figure 9 shows a two-ply label containing a tester circuit for a battery;

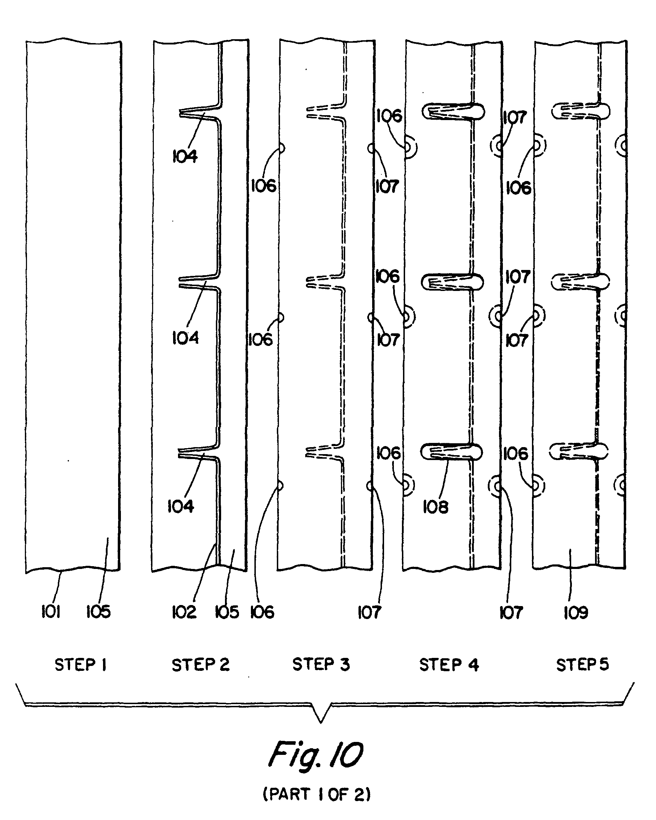

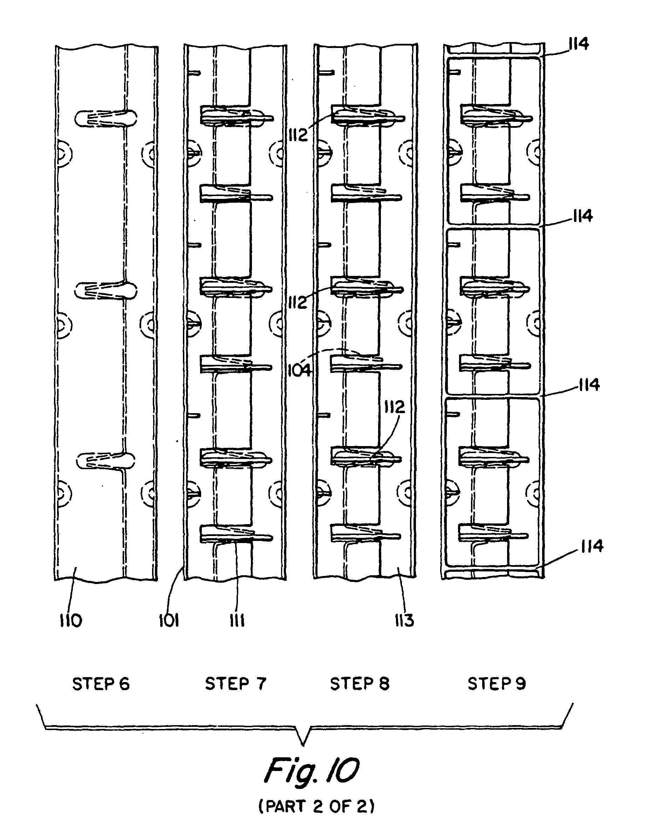

Figure 10 shows a stepwise method for making a label with a tester circuit for a battery; and

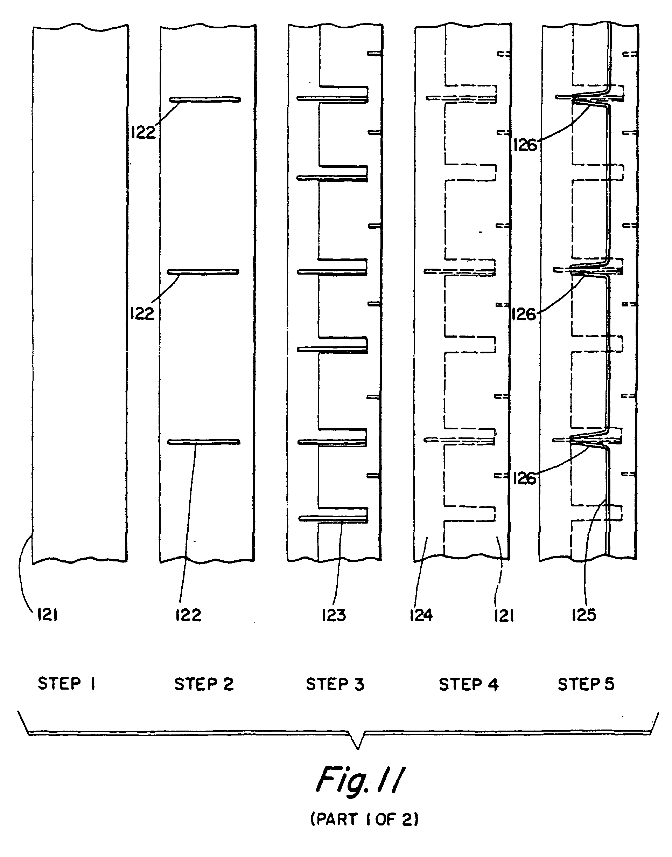

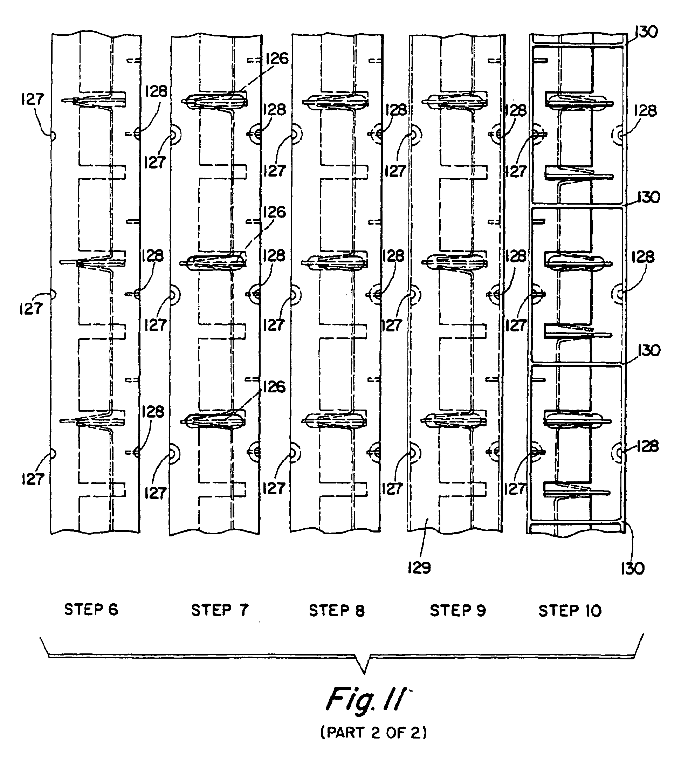

Figure 11 shows an alternative stepwise method for making a label with a tester circuit for a battery.

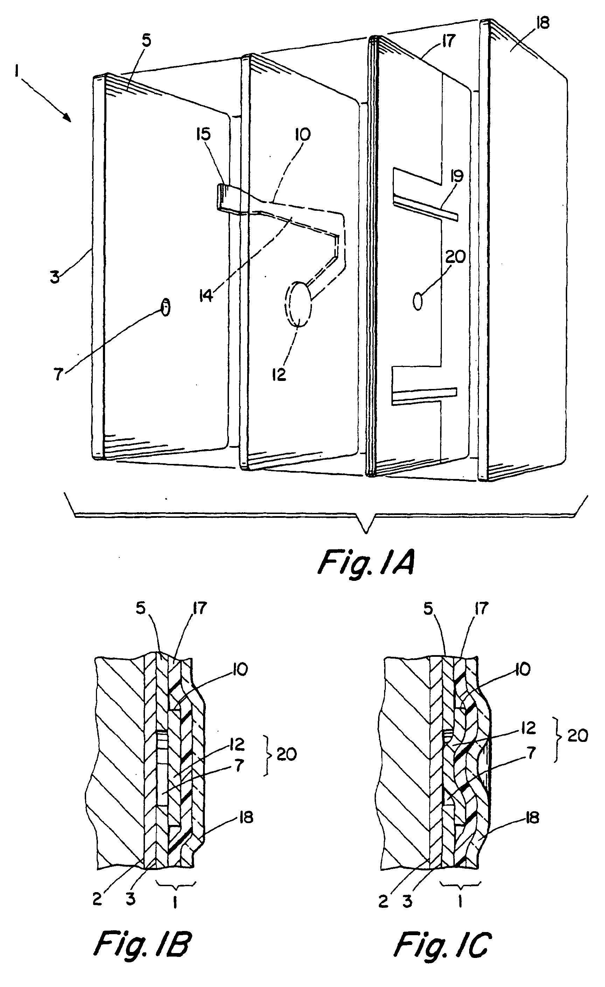

Referring to the Figures, Figure 1A shows an exploded view of a tester label 1. Insulative layer 5 has opening 7. On one side of insulative layer 5 is adhesive layer 3. This side of the label 1 is to be adhered to the conductive housing of a battery. On the surface of insulative layer 5 opposite the surface containing adhesive layer 3, is a tester circuit 10. The tester circuit 10 will be located directly on the surface of insulative layer 5. The tester circuit 10 is of an electrically conductive material and has a first terminal contact end 12 disposed over opening 7 in the insulator layer 5. Connected to the first terminal contact end 12 is an area of controlled resistivity 14. This area is connected to the second terminal contact end in the form of tab 15 that may be placed in contact with a terminal of the battery. Over the tester circuit 10 is disposed label substrate 17. This layer comprises thermally sensitive material 19. This layer may also contain printing and be made of plastic. This layer further comprises switch area 20 aligned with the first terminal contact end 12 and opening 7. Thus, the tester circuit 10 can be completed by establishing contact between first terminal contact end 12 through opening 7 to a conductive battery housing by depressing switch area 20.

The thermally sensitive material 19 is disposed in thermally transferable contact with the area of increasing resistivity 14 of tester circuit 10. Optionally, protective layer 18 may be placed over label substrate layer 17. Each of the individual layers may range in thickness from about 0.5 to about 2 mils (i.e. from about 0.0005 to about 0.002 inch, or from about 12 to about 50 µm).

Figure 1B shows a side view of a portion of an assembled label attached to a battery. Label 1 has insulative layer 5 adhered to can 2 by adhesive layer 3. Insulative layer 5 has opening 7. Next to the insulative layer 5 is the end 10 of the tester circuit layer. The label 1 is completed with label substrate layer 17 next to tester circuit layer 10 and has protective layer 18 disposed on top of it.

In Figure 1C, the tester label 1 is activated by depressing the label at the switch area 20 over opening 7. Thus, end 12 of tester circuit 10 is placed in contact with can 2.

In Figure 2, label 1 has adhesive layer 3, label substrate layer 17, and optional protective layer 18 (c.f. Figure 1). Insulative layer 6 has an opening 8 and a tab 19. An additional insulative layer 21 is disposed on one surface of the first insulative layer 6. This additional insulative layer 21 has an opening 24 aligned with opening 8 in the first insulative layer 6, and a second opening 25 aligned with a portion of the tab 19.

Over the second insulative layer 21 is disposed tester circuit 28. This tester circuit has a first terminal contact end 29 aligned with opening 24 in the second insulative layer 21 and a second terminal contact end 30 aligned with the second opening 25 in the second insulative layer 21. The tester circuit 28 has an area of controlled resistivity 32 connecting first terminal contact end 29 and second terminal contact end 30. Label substrate layer 17 contains thermally sensitive material 22 in alignment with the tester circuit area 32.

The label substrate layer 17 has two switch areas 33 and 34. Switch area 33 is aligned with the first terminal contact end 29 of the tester circuit 28, and switch area 34 is aligned with the second terminal contact end 30 of tester circuit 28.

In Figure 3, label 1 has protective layer 18, adhesive layer 3 and label substrate layer 17. Additionally, the label 1 has an insulative layer 36 having a positive terminal connector 38 and a negative terminal connector 39. Positive terminal connector 38 has a tab 40 that will contact the positive terminal of the battery, and negative terminal connector 39 has a tab 41 that will contact the negative terminal of the battery.

Next to insulative layer 36 is disposed a second insulative layer 37. This insulative layer 37 has a first opening 42 disposed over the positive terminal connector 38, and a second opening 43 aligned with the negative terminal connector 39.

The next layer 44 in label 1 contains the tester circuit 45 with first terminal contact end 47, and second terminal contact end 48 connected to each other via an area of controlled resistivity 50. The first terminal contact end 47 is aligned with the first opening 42 in insulative layer 37, and the second terminal contact end 48 is aligned with the second opening 43.

Label substrate 17, disposed over tester circuit layer 44, has a first switch area 51 and a second switch area 52, and has thermally sensitive material 49. The first switch area 51 is aligned with first terminal contact end 47 of tester circuit 45, and the second switch area 52 is aligned with second terminal contact end 48. Because insulative layer 37 has openings 42 and 43, tester circuit 45 is open. Both contact ends 47 and 48 are out of contact with the battery terminals. By pressing both switch areas 51 and 52, terminal contact ends 47 and 48 may be placed in contact with terminal connectors 38 and 39 through openings 42 and 43 to complete the tester circuit 45.

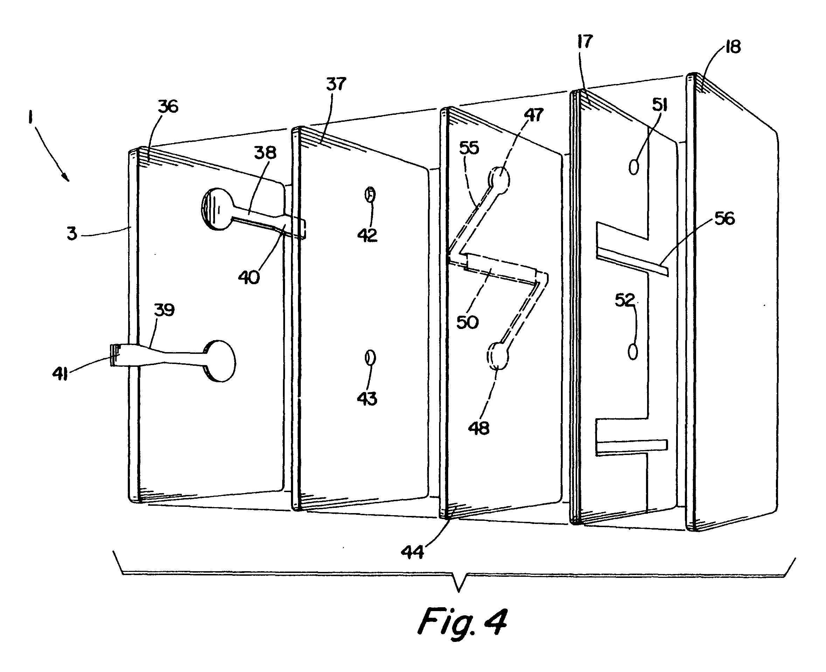

In Figure 4, the area of controlled resistivity 50 and thermally sensitive material 56 are configured to run axially along the side of the battery to be labelled.

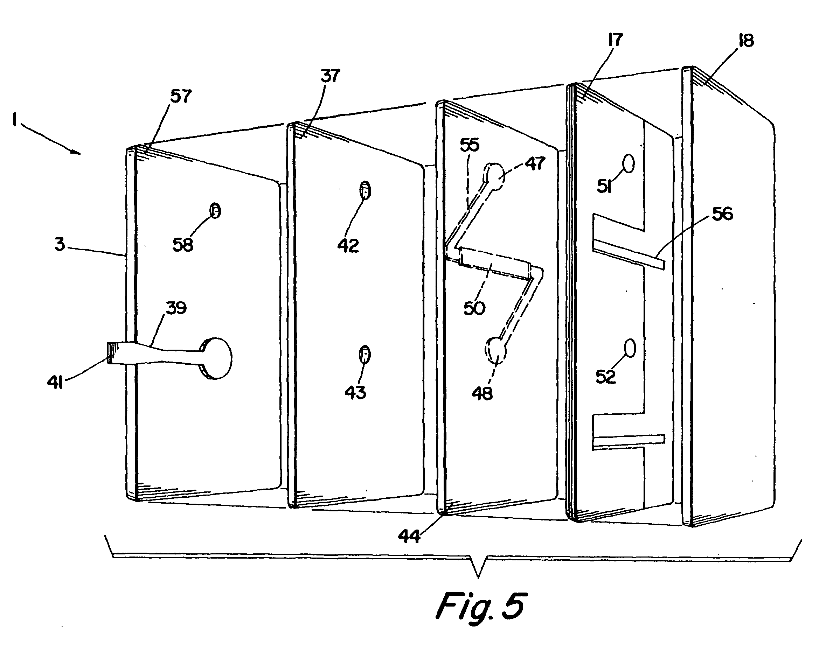

The label 1 in Figure 5 is similar to that in Figure 4. The label 1 has an insulative layer 57 that contains an opening 58 and a negative terminal connector 39. Opening 58 permits contact between end 47 of tester circuit 55 and the housing of a battery to be labelled.

In Figure 6, label 1 is adhered to a battery 64. Terminal contact tab 65 is shown as extending over and in contact with the bottom 66 of battery 64. In this tab configuration, it may be desirable to have a recessed area in the battery can bottom for the tab to rest. Switch areas 62 and 63 are shown to be on diametrically opposite sides of the battery 64 and can be readily activated by thumb and forefinger pressure.

In Figure 7A and 7B, the bottom of a battery and the tab contact between the tester circuit in the label and a battery terminal are shown. In 7A, the battery has container 70 with opening 72. The opening 72 is closed with first cover 73 that contacts anode current collector 75. Cover 73 is sealed and secured to container 70 by seal 71. Insulative annular washer 74 is placed over the opening 72 in container 70. Negative cover 76 is disposed over the annular washer 74 and is in contact with the anode current collector 75 to provide the negative terminal for the battery. Label substrate end 86 of label 80 extends over onto negative cover 76.

In 7B, the encircled portion of Figure 7A is enlarged. The label 80 has insulative layer 81 disposed next to container 70. The terminal contact tab 82 is an extension of the tester circuit of the label and extends over and into contact with cover 76 at area 83. The label substrate end 86 extends completely over terminal contact tab 82 to conceal it. To complete labelling of the battery, the extension of label substrate 86 is heat-shrunk over and around the periphery of cover 76 to ensure good electrical contact between contact tab 82 and cover 76.

Figure 7C shows an enlarged portion of the bottom of a battery and the terminal contact tab 82, wherein tab contact 82 is spaced apart from the battery terminal, cover 76, so as to serve as a switch. In this embodiment, cover 76 is shaped to have a central raised portion 78 and a peripheral lower shoulder 79. Contact tab 82 and the extension of label substrate 86 in this embodiment are out of contact with shoulder 79 until external pressure is exerted on that area to force tab 82 into contact with shoulder 79 of cover 76, thereby closing the circuit and activating the tester.

In Figure 8 is shown an embodiment of the invention wherein permanent contact between the cover 76 and terminal contact tab 82 is ensured through the use of a plastic snap ring 85 which is forced into the peripheral junction between cover 76 and battery container 70 to hold tester contact tab 82 and the extension of label substrate 86 firmly in contact with cover 76. This embodiment may provide the additional function of cell reversal protection because of the extension of the top of the snap ring 85 above the cover 76.

In Figure 9 a two-ply label is shown. Label 90 has base insulative film 91 with opening 92 and tester circuit 93. Tester circuit 93 has terminal contact tab 94, area of controlled resistivity 95 and terminal contact end 96. Protective layer 97 is placed over base film layer 91. As the label 90 is applied onto and wrapped around a battery, opening 92 will be aligned with terminal contact end 96.

In Figure 10, the steps for making the label with a tester are shown. In Steps 1 to 6, the label is viewed from the back side and in Steps 7 to 9 the label is viewed from the front side. In step 1, a base film layer 101 of PVC is metallised with aluminium. In Step 2, a portion 102 of the aluminium is removed in the pattern of the tester circuit. Next, an electrical insulator is applied in Step 3 onto the metallised surface 105, with ends 106 and 107 exposed to provide contact with the terminals of the battery. Extra insulation 108 is applied in Step 4 to area 104 of the tester circuit and ends 106 and 107. In Step 5, a pressure sensitive adhesive 109 is applied to the surface of the label, and in Step 6 the label is applied to a silicone-coated paper 110. In Step 7, the opposite side of the base PVC film 101 is printed with the label graphics 111. In step 8, a contrasting colour layer and then the thermochromic ink 112 are placed over the area 104 of the tester circuit, and a protective film 113 is applied over the label. Finally, in Step 9, the label is die-cut at points 114 to provide the individual labels.

The steps may be reversed as shown in Figure 11, with the outer protective layer forming the initial layer. The label is viewed from the back or the battery side. In Step 1, the protective film 121 is formed. In Step 2, the thermochromic ink 122 and then a contrasting colour layer are placed on the film. The label is printed with graphics 123 in Step 3 and is laminated to metallised PVC in Step 4. The metallised surface 124 is on the surface of the PVC opposite of the surface next to the protective film 121. In Step 5 the metallised layer is etched in the tester circuit pattern 125 with area of controlled resistivity 126. In Step 6 an electrical insulator is applied over the metallised surface 124 of the PVC film. Ends 127 and 128 are exposed to provide terminal contact ends for the tester circuit. In Step 7 additional insulation is placed around area 126 and ends 127 and 128 of the tester circuit. Adhesive is applied over the insulator in Step 8 and the label strip is laminated to a silicone-coated paper carrier 129 in Step 9. Finally, in Step 10 the labels are die cut at 130 to the proper size.

It will be appreciated that the tester circuit shown in these Figures may of course be varied. The portion of the metallised surface may be exposed at different areas to provide different switch areas. To provide shrink tube labels, the labels may be formed according to the above steps and then applied around a mandrel and welded to form a tube.

In a further modification, a single-ply label may be assembled (not shown here). A heat shrinkable plastic film, for example, PVC with 50% shrinkage in the machine direction, may be used as the base film on which is reverse printed the indicated material. Suitable graphics are then printed on the film. The conductive layer is added next by printing a conductive ink, by hot stamping or by the use of a metal foil or a metallised plastic insert. An insulation pattern is then added over the conductive layer, for example, by printing a foaming ink or applying a layer of insulating material such as a thin foamed plastic layer. A layer of adhesive is then added and the label is laminated to a silicone-coated paper carrier as described above. If desired, a single-ply label may be made using non-shrinkable plastic in conjunction with an outer heat-shrinkable tube.

## Claims

1. A battery (64) having a label (1) and a tester therefor, the tester forming part of the label (1) and comprising a circuit (10) whose ends (12, 15) contact or are contactible with the terminals (66, 70) of the battery, a portion of the circuit (10) between the two ends (12, 15) providing an area of predetermined resistance (14), an indicator (19) being associated with the area of resistance and being activatable thereby by a current flowing therethrough, activation of the indicator (19) giving an indication of the remaining power in the battery, wherein the circuit (10) consists of an electrically conductive material having two ends (12, 15) connected to each other via the area of predetermined resistance, connection with neither terminal being made via an extra conductive foil adhesive strip, **characterised in that** one of the ends (12, 15) is biased away from the associated terminal (66, 70), manual pressure being sufficient to complete the circuit with the battery (64).

2. A battery (64) according to claim 1, wherein the tester is in the form of films printed onto the label (1).

3. A battery (64) according to claim 1 or 2, wherein the indicator is a thermochromic or electrochromic ink.

4. A battery (64) according to any preceding claim, wherein the tester only indicates whether the battery (64) has discharged to a predetermined level.

5. A battery (64) according to any preceding claim wherein the tester is calibrated so that, when the battery (64) is tested, an impression of remaining battery (64) life is obtained.

6. A battery (64) according to claim 5, wherein the tester has varied resistance along its length.

7. A battery (64) according to claim 6, wherein the variation in resistance is effected by varying the width of the tester, so that the narrowest point would heat up the most, the widest point heating up when the battery (64) has a useful degree of charge.

8. A battery (64) according to any of claims 5 to 7, wherein the tester or label (1) further comprises a printed scale to give an indication of battery (64) life-expectancy.

9. A battery (64) according to any preceding claim, wherein one end of the circuit (10) is secured to one of the terminals (12, 15), and the other end of the circuit (10) is biased away from its terminal, manual pressure being sufficient to complete the circuit with the battery.

10. A battery (64) according to claim 9, wherein the label (1) has two layers, with a hole (7) in the bottom layer (5) and an end (12) of the circuit (10) located over this hole (7) but attached to the top layer (17), so that pressure on the top layer (17) then causes contact with the terminal, such as the battery (64) casing (70), the resilience of the upper layer (86) then allowing the end (12) to spring back after testing.

## Patentansprüche

1. Batterie (64) mit einem Etikett (1) und einem dazugehörigen Tester, wobei der Tester einen Teil des Etiketts (1) bildet und eine Schaltung (10) aufweist, deren Enden (12, 15) mit den Anschlüssen (66, 70) der Batterie in Kontakt sind oder in Kontakt bringbar sind, wobei ein Bereich der Schaltung (10) zwischen den Enden (12, 15) einen Bereich mit einem vorbestimmten Widerstand (14) aufweist, wobei eine Anzeigeeinrichtung (19) dem Bereich mit dem Widerstand zugeordnet ist und dadurch durch einen hindurchfließenden Strom aktivierbar ist, wobei eine Aktivierung der Anzeigeeinrichtung (19) eine Anzeige der in der Batterie verbleibenden elektrischen Energie liefert, wobei die Schaltung (10) aus einem elektrisch leitenden Material mit den zwei über den Bereich mit dem vorbestimmten Widerstand miteinander verbundenen Enden (12, 15) besteht, wobei eine Verbindung mit keinem Anschluß über einen leitenden zusätzlichen Folienhaftstreifen gebildet ist,
**dadurch gekennzeichnet,**
**daß** das eine der Enden (12, 15) von dem zugeordneten Anschluß (66, 70) weg gespannt ist, wobei ein manueller Druck ausreicht, um die Schaltung mit der Batterie (64) zu schließen.

2. Batterie (64) nach Anspruch 1,
wobei der Tester in Form von auf das Etikett (1) gedruckten Filmen vorliegt.

3. Batterie (64) nach Anspruch 1 oder 2,
wobei die Anzeigeeinrichtung eine thermochrome oder elektrochrome Tinte ist.

4. Batterie (64) nach einem der vorhergehenden Ansprüche,
wobei der Tester nur anzeigt, ob sich die Batterie (64) auf einen vorbestimmten Pegel entladen hat.

5. Batterie (64) nach einem der vorhergehenden Ansprüche,
wobei der Tester derart kalibriert ist, daß beim Testen der Batterie (64) ein Eindruck der verbleibenden Lebensdauer der Batterie (64) erhältlich ist.

6. Batterie (64) nach Anspruch 5,
wobei der Tester entlang seiner Länge einen veränderlichen Widerstand aufweist.

7. Batterie (64) nach Anspruch 6,
wobei die Widerstandsänderung durch eine Änderung der Breite des Testers bewirkt wird, so daß sich der schmalste Punkt am meisten aufheizt und sich der breiteste Punkt dann aufheizt, wenn die Batterie (64) einen nützlichen Ladegrad aufweist.

8. Batterie (64) nach einem der Ansprüche 5 bis 7,
wobei der Tester oder das Etikett (1) ferner eine gedruckte Skala zur Anzeige der Lebenserwartung der Batterie (64) aufweist.

9. Batterie (64) nach einem der vorhergehenden Ansprüche,
wobei das eine Ende der Schaltung (10) an einem der Anschlüsse (12, 15) befestigt ist und das andere Ende der Schaltung (10) von seinem Anschluß weg gespannt ist, wobei ein manueller Druck ausreicht, um die Schaltung mit der Batterie zu schließen.

10. Batterie (64) nach Anspruch 9,
wobei das Etikett (1) zwei Schichten aufweist, mit einem Loch (7) in der unteren Schicht (5) und mit einem über diesem Loch (7) gelegenen, aber an der oberen Schicht (17) angebrachten Ende (12) der Schaltung (10), so daß ein Druck auf die obere Schicht (17) dann den Kontakt mit dem Anschluß bewirkt, wie zum Beispiel dem Gehäuse (70) der Batterie (64), wobei die Elastizität der oberen Schicht (86) es dann ermöglicht, daß das Ende (12) nach dem Testen zurückspringt.

## Revendications

1. Pile (64) comportant une étiquette (1) et un testeur pour cette pile, le testeur faisant partie de l'étiquette (1) et comprenant un circuit (10) dont les extrémités (12,15) sont en contact ou peuvent être mises en contact avec les bornes (66,70) de la pile, une partie du circuit (10) entre les deux extrémités (12,15) constituant une zone de résistance prédéterminée (14), un indicateur (19) étant associé à la zone de résistance et pouvant être activé de ce fait par un courant qui la traverse, une activation de l'indicateur (19) donnant une indication de la puissance restante dans la pile, dans laquelle le circuit (10) est constitué par un matériau électriquement conducteur comportant deux extrémités (12,15) connectées l'une à l'autre par l'intermédiaire de la zone de résistance prédéterminée, une connexion avec aucune borne étant réalisée par l'intermédiaire d'une bande adhésive sous la forme d'une feuille conductrice supplémentaire, **caractérisée en ce que** l'une des extrémités (12,15) est sollicitée à l'écart de la borne associée (66,70), une pression manuelle étant suffisante pour fermer le circuit avec la pile (64).

2. Pile (64) selon la revendication 1, dans laquelle le testeur se présente sous la forme de films imprimés sur l'étiquette (1).

3. Pile (64) selon la revendication 1 ou 2, dans laquelle l'indicateur est une encre thermochromique ou électrochromique.

4. Pile (64) selon l'une quelconque des revendications précédentes, dans laquelle le testeur indique seulement si la pile (64) a été déchargée jusqu'à un niveau prédéterminé.

5. Pile (64) selon l'une quelconque des revendications précédentes, dans laquelle le testeur est étalonné de telle sorte que, lorsque la pile (64) est testée, on obtient une évaluation de la durée de vie restante de la pile (64) .

6. Pile (64) selon la revendication 5, dans laquelle le testeur présente une résistance qui varie le long de sa longueur.

7. Pile (64) selon la revendication 6, dans laquelle la variation de résistance est réalisée en faisant varier la largeur du testeur de telle sorte que le point le plus étroit s'échauffe au maximum, le point le plus large s'échauffant lorsque la pile (64) présente un degré de charge utile.

8. Pile (64) selon l'une quelconque des revendications 5 à 7, dans laquelle le testeur ou l'étiquette (1) comprend en outre une échelle imprimée pour donner une indication de la durée de vie attendue de la pile (64).

9. Pile (64) selon l'une quelconque des revendications précédentes, dans laquelle une extrémité du circuit (10) est fixée à l'une des bornes (12, 15) et l'autre extrémité du circuit (10) est éloignée de sa borne, une pression manuelle suffisant pour fermer le circuit avec la pile.

10. Pile (64) selon la revendication 9, dans laquelle l'étiquette (1) comporte deux couches, un trou (7) étant ménagé dans la couche inférieure (5) et une extrémité (12) du circuit (10) étant située au-dessus de ce trou (7) mais étant liée à la couche supérieure (17) de telle sorte qu'une pression sur la couche supérieure (17) génère alors un contact avec la borne telle que le boîtier (70) de la pile (64), l'élasticité de la couche supérieure (86) permettant alors à l'extrémité (12) de réaliser un rappel élastique après le test.
